Europäisches Patentamt

European Patent Office

Office européen des brevets

(11) Publication number: **0 295 134**
**A2**

# (12) EUROPEAN PATENT APPLICATION

(21) Application number: **88305343.1**

(22) Date of filing: **10.06.88**

(51) Int. Cl.⁴: **G 01 V 3/32**
**G 01 N 24/08**

(30) Priority: **11.06.87 US 61356**

(43) Date of publication of application:
**14.12.88 Bulletin 88/50**

(84) Designated Contracting States:
**AT BE CH DE ES FR GB GR IT LI LU NL SE**

(71) Applicant: **NUMAR CORPORATION**
**279 Great Valley Parkway**
**Malvern PA 19355 (US)**

(72) Inventor: **Taicher, Zvi**
**Apartment 7 2 Sitkoff Street**
**Rehovot (IL)**

**Shtrikman, Shmuel**
**Weizmann Institute of Science**
**Rehovot (IL)**

(74) Representative: **Pilch, Adam John Michael et al**
**c/o D. Young & Co. 10 Staple Inn**
**London WC1V 7RD (GB)**

(54) Nuclear magnetic resonance sensing apparatus and methods.

(57) NMR sensing apparatus, which may be used in well logging, includes a magnet arrangement (10) for generating a static magnetic field in a toroidal region (9) containing materials to be analyzed. The magnet arrangement (10) includes at least four magnets arranged along a longitudinal axis (11) which may coincide with the axis of, for example, a bore hole (7) being investigated. A coil arrangement (16) is used both for generating an r.f. magnetic field in the region (9) so as to excite nuclei of the materials to be analyzed, and for receiving NMR signals from the excited nuclei. An indication of the properties of the materials being analyzed is then obtained from the received NMR signals by means of a computer (32).

FIG 1

## Description

## NUCLEAR MAGNETIC RESONANCE SENSING APPARATUS AND METHODS

The present invention relates to nuclear magnetic resonance (NMR) sensing apparatus and methods, which have particular but not exclusive application to sensing in a cylindrical volume surrounding a probe, inter alia in well logging.

The description of this invention and its background will be approached in the context of well logging, because well logging is one application of the invention. There is however no intention to limit the generality of the present invention to the field of well logging.

Fluid flow properties of porous media have long been of interest in the oil industry. A. Timur, in "Pulsed Nuclear Magnetic Resonance Studies of Porosity, Movable Fluid, and Permeability of Sandstone" (Journal of Petroleum Technology, June 1969, p. 775), proved experimentally that NMR methods provide a rapid, nondestructive determination of porosity, movable fluid, and permeability of rock formation.

It is known that when an assembly of magnetic moments such as those of hydrogen nuclei are exposed to a static magnetic field, they tend to align along the direction of the magnetic field, resulting in bulk magnetization. The rate at which equilibrium is established in such bulk magnetization upon provision of the static magnetic field is characterized by the parameter T1, the spin-lattice relaxation time.

It has been observed that the mechanism which determines the value of T1 depends on molecular dynamics. In liquids, molecular dynamics is a function of molecular size and intermolecular interactions. Therefore, water and different types of oil have different T1 values.

In a heterogeneous medium, such as a porous solid which contains liquid in its pores, the dynamics of the molecules close to the solid surface are also significant, and they differ from the dynamics of the bulk liquid. It may thus be appreciated that the T1 parameter provides valuable information relating to well logging parameters.

There exist a number of techniques for disturbing the equilibrium of an assembly of magnetic moments such as those of hydrogen nuclei, for T1 parameter measurements. One such technique is exemplified by the Schlumberger Nuclear Magnetic Logging Tool.

The Schlumberger Nuclear Magnetic Logging (NML) tool is described in R.C. Herrick, S.H. Courturie, and D.L. Best, "An Improved Nuclear Magnetism Logging System and its Application to Formation Evaluation" (SPE 8361 presented at the 54th Annual Fall Technical Conference and Exhibition of the Society of Petroleum Engineers of AIME, held in Las Vegas, Nevada, September 23-26, 1979), and in R.J.S. Brown et al, U.S. Patent 3,213,357, entitled "Earth Formation and Fluid Material Investigation by Nuclear Magnetism Relaxation Rate Determination".

The Schlumberger Nuclear Magnetic Logging (NML) tool measures the free precession of proton nuclear magnetic moments in the earth's magnetic field by applying a relatively strong DC polarizing field to the surrounding rock formation, in order to align proton spins approximately perpendicular to the earth's magnetic field. The polarizing field must be applied for a period roughly five times T1 (the spin-lattice relaxation time) for sufficient polarization -approximately 2 seconds (See the Herrick et al. reference mentioned above). At the end of polarization, the field is turned off rapidly. Since the proton spins are unable to follow this sudden change, they are left aligned perpendicular to the earth's magnetic field and precess about this field at the Larmor frequency corresponding to the earth's local magnetic field (roughly from 1300 to 2600 Hz, depending on location).

The spin precession induces, in a pickup coil, a sinusoidal signal whose amplitude is proportional to the density of protons present in the formation. The signal decays with a time constant $T2^*$ (transverse relation time) due to inhomogeneities in the local magnetic field over the sensing volume.

Hydrogen protons in solids or bound to surfaces have very short characteristic relaxation times T1; however, bulk fluids in pore spaces have much longer relaxation times. In view of the fact that the observed decay with a relaxation time constant $T2^*$ is less than or equal to T1, the Schlumberger NML tool is blinded to matrix and bound protons by delaying observation of the signal until 20-30 milliseconds after the beginning of decay. T1 measurements can be performed by comparison of free precession following polarizing pulses of differing duration. Because the large polarizing field cannot be turned off instantly, much of the signal amplitude is lost.

At present there are two ways to compensate for this effect:

1. U.S. Patent 3,483,465, to J.M. Baker, entitled "Nuclear magnetic logging system utilizing an Oscillated Polarizing Field," employs a polarizing field which is allowed to oscillate at the Larmor frequency corresponding to the earth's magnetic field for a few cycles.

2. U.S. Patent 3,667,035, to Slichter, entitled "Nuclear Magnetism Logging," describes applying an alternating magnetic field in a direction transverse to the earth's magnetic field and at a frequency corresponding to the Larmor precession frequency corresponding to the earth's magnetic field.

Although there have been major improvements in the Schlumberger nuclear magnetic logging (NML) technique during the last 25 years, the following disadvantages have not yet been overcome:

1. Species with short relaxation time (shorter than 20-30 msec) cannot be detected by the Schlumberger NML technique due to long dead time of the system following the polarizing DC pulse.

2. The Schlumberger NML technique involves the suppression of a very high undesired signal coming from the bore fluid (which is in close proximity to the probe) and requires doping of the bore fluid with paramagnetic materials. This process is costly and time consuming.

3. The Schlumberger NML technique cannot carry out a T1 (spin-lattice relaxation time) measurement at a commercially operational logging speed due to the long time required for each single T1 measurement.

Another technique for nondestructive determination of porosity, movable fluid, and permeability of rock formation is the Los Alamos NMR technique described in the following publication:

R. K. Cooper and J. A. Jackson "Remote (Inside-Out) NMR. I Production of a Region of Homogeneous Magnetic Field," J. Magn. Reson. 41,400 (1980);

L. J. Burnett and J. A. Jackson, "Remote (Inside-Out) NMR. II Sensitivity of NMR Detection for External Samples," J. Magn. Reson. 41,406 (1980);

J. A. Jackson, L. J. Burnett and J. F. Harmon, "Remote (Inside-Out) NMR. III Detection of Nuclear Magnetic Resonance in a Remotely Produced Region of Homogeneous Magnetic Field," J. Magn. Reson. 41,411 (1980);

U.S. Patent 4,350,955, to J. A. Jackson et al., entitled "Magnetic Resonance Apparatus."

The Los Alamos NMR technique is based on the development of a new type magnet/RF coil assembly. This allows one to obtain the NMR signal mostly from a toroidal "doughnut" shaped region in the surrounding rock formation at a specified distance from the bore hole axis.

The Los Alamos approach is based on T1 measurements only, which are achieved by standard pulse NMR techniques which allow one to overcome one of the difficulties noted above in connection with the Schlumberger technique, i.e. the problem of the long dead time. However, it does not eliminate the bore fluid signal problem nor does it overcome the difficulty of unacceptably low operational speeds due to low signal to noise ratio. Jackson proposes to increase significantly the static magnetic field strength but admits that this is impractical at the present state of magnet technology.

A basic difficulty with the Los Alamos approach of Jackson lies in the fact that there is defined a "doughnut" shaped region having high homogeneity, whose location and field strength tend to vary over time during operation, due in part to changes in the local earth's magnetic field, temperature, and mechanical parameters of the field producing apparatus. The Los Alamos approach, employing an antenna which is tuned to a fixed frequency, lacks the flexibility to resonantly match the changing field.

A similar difficulty is encountered using a technique described in U.K. Patent Application 2,141,236A, published 12 December, 1984, entitled "Nuclear Magnetic Logging".

Another basic difficulty associated with any technique wherein a relatively small size, high homogeneity region is examined, lies in the fact that each single measurement of the decay process must have a duration approximately as long as the relevant relaxation time. The tool must be present in the local region of measurement throughout this duration, thus restricting the logging operation to non-economical logging speeds.

The present applicants have proposed in U.S. Patent Application No. 08/838,503 entitled "Nuclear magnetic resonance sensing apparatus and techniques" nuclear magnetic resonance apparatus having performance which is significantly improved over that of the prior art, and which yields additional operational possibilities not available to previous apparatus and techniques. The improvements produced by that apparatus lie in reducing spurious signals, significantly enhancing signal to noise ratio, the possibility of measurement of the diffusion coefficient of the fluid in the rock formation, and two dimensional imaging.

The present invention seeks to provide nuclear magnetic resonance (NMR) apparatus having performance which is significantly improved over that of the prior art, and which yields additional operational possibilities not available to previous apparatus and techniques. The improvements produced by the present invention may include significantly enhanced signal to noise ratios.

In accordance with one aspect of the invention there is provided nuclear magnetic resonance sensing apparatus comprising at least four magnets operative to generate a static magnetic field in a region remote therefrom containing materials sought to be analyzed, the at least four magnets being arranged along a longitudinal axis, and being magnetized in magnetization directions extending generally parallel to the longitudinal axis, means for generating a radio frequency magnetic field in said remote region for exciting nuclei of the materials sought to be analyzed, and means for receiving nuclear magnetic resonance signals from the excited nuclei and for providing an output indication of the properties of the materials sought to be analyzed.

In accordance with a preferred embodiment of the present invention, to be described in greater detail hereinafter, the apparatus includes a first pair of magnets having opposite magnetization directions and being spaced along the longitudinal axis and a second pair of magnets disposed intermediate the first pair of magnets along the longitudinal axis and having magnetization directions opposite to the magnetization directions of adjacent ones of the first pair of magnets.

According to an alternative embodiment of the invention, the second pair of magnets have magnetization directions parallel to the magnetization directions of adjacent ones of the first pair of magnets.

Further in accordance with the preferred embodiment, the magnets are each of generally circular cylindrical configuration.

The magnets may be permanent magnets, electromagnets or a combination thereof.

In accordance with another aspect of the invention there is provided nuclear magnetic resonance sensing apparatus comprising:

at least four ferrite permanent magnets operative to generate a static magnetic field in a region remote therefrom containing materials sought to be analyzed, said at least four ferrite permanent magnets being of generally cylindrical configuration, the at least four ferrite permanent magnets being arranged along a longitudinal axis and being magnetized in magnetization directions extending generally parallel to said longitudinal axis;

means for generating a radio frequency magnetic field in said remote region for exciting nuclei of the materials sought to be analyzed, said generating means comprising at least one coil wound about the surface of said at least four ferrite permanent magnets whereby the coil turns lie in planes substantially perpendicular to said longitudinal axis intermediate the magnets; and

receiving means for receiving, via said at least one coil, nuclear magnetic resonance signals from the materials to be analyzed and for providing an output indication of the properties of the materials sought to be analyzed.

In accordance with a further aspect of the invention there is provided a method of nuclear magnetic resonance sensing comprising the steps of providing at least four magnets operative to generate a static magnetic field along a direction perpendicular to a longitudinal axis in a toroidal region arranged approximately in a plane perpendicular to the longitudinal axis intermediate the magnets and remote from the longitudinal axis, which region contains materials to be analyzed, the at least four magnets being arranged along the longitudinal axis and being magnetized in magnetization directions extending generally parallel to the longitudinal axis, causing the at least four magnets to generate a static magnetic field of generally uniform amplitude in the remote region, generating a radio frequency magnetic field in the remote region for exciting nuclei of the materials sought to be analyzed and having a radio frequency magnetic field direction substantially parallel to the longitudinal axis and perpendicular to the static field direction, receiving nuclear magnetic resonance signals from the excited nuclei, and providing in response to the received nuclear magnetic resonance signals an output indication of the properties of the materials sought to be analyzed.

In accordance with a still further aspect of the invention there is provided apparatus for well logging using nuclear magnetic resonance and including at least four magnets operative to generate a static magnetic field in a region remote therefrom containing materials sought to be analyzed, the at least four magnets being arranged along a longitudinal axis and being magnetized in magnetization directions extending generally parallel to the longitudinal axis, apparatus for generating a radio frequency (RF) magnetic field in the region in a direction substantially parallel to the axis of the bore hole and perpendicular to the static magnetic field for exiting nuclei of the materials sought to be analyzed, and apparatus for receiving nuclear magnetic resonance signals from the excited nuclei.

The properties of the materials measured by embodiments of the present invention may include porosity, movable fluid porosity, permeability of rock formation, T1 (spin-lattice relaxation time) and T2* (transverse relaxation time).

The invention will now be described by way of example with reference to the accompanying drawings, throughout which like parts are referred to by like references, and in which:

Fig. 1 is a partly pictorial and partly block diagram illustration of well logging apparatus constructed and operative in accordance with a preferred embodiment of the present invention;

Fig. 2 is a sectional illustration of the apparatus of Fig. 1 taken in a plane in which lies the axis of the bore hole indicated by the lines 2-2 in Fig. 1 and illustrating the arrangements of the static and radio frequency magnetic fields;

Figs. 3A and 3B are sectional illustrations (not drawn to scale) of magnet configurations of Fig. 1, taken in a plane in which lies the axis of the bore hole indicated by the lines 2-2 in Fig. 1, useful in the present invention; and

Figs. 4A, 4B, 4C and 4D are diagrammatic illustrations of field characteristics produced by the apparatus of Figs. 1-3.

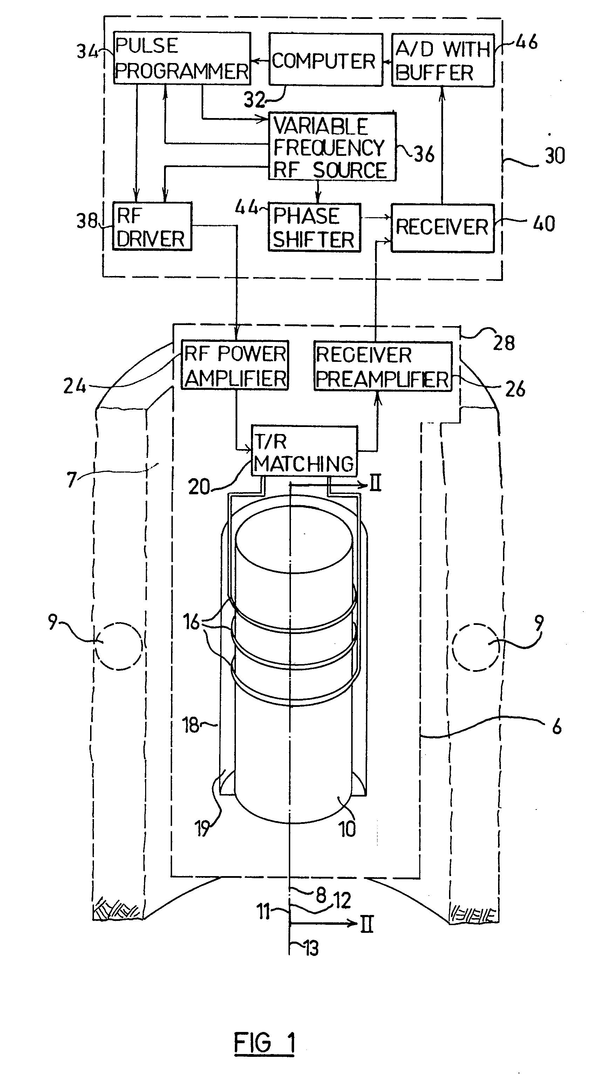

Reference is now made to Fig. 1, which illustrates in general form, well logging apparatus constructed and operative in accordance with a preferred embodiment of the invention disposed in a portion of a bore hole. The apparatus includes a first portion 6, which is arranged to be lowered into a bore hole 7, having a bore hole longitudinal axis 8, in order to examine the nature of materials in the vicinity of the bore hole, lying in a region 9 of generally toroidal configuration and surrounding the bore hole.

The first portion 6 preferably comprises a generally cylindrical permanent magnet assembly 10, preferably having a circular cross section and arranged along a permanent magnet longitudinal axis 11 which is preferably coaxial with the longitudinal axis 8 of the bore hole. According to a preferred embodiment of the invention a plurality of permanent magnets 10, normally, at least four in number, may be employed. Throughout the specification, the plurality of permanent magnets defining magnet assembly 10 will be considered together and referred to as permanent magnet assembly 10 and their common longitudinal axis will be identified as longitudinal axis 11.

According to a preferred embodiment of the invention, the permanent magnet assembly 10 comprises at least four permanent magnets including a first pair of magnets having opposite magnetization directions and being spaced along the longitudinal axis and a second pair of magnets disposed intermediate the first pair of magnets along the longitudinal axis and having magnetization directions opposite to the magnetization directions of the magnets of the first pair of magnets adjacent thereto. According to an alternative embodiment of the present invention, the second pair of magnets have magnetization directions codirectional with respect to the magnetization directions of the magnets of the first pair of magnets adjacent thereto.

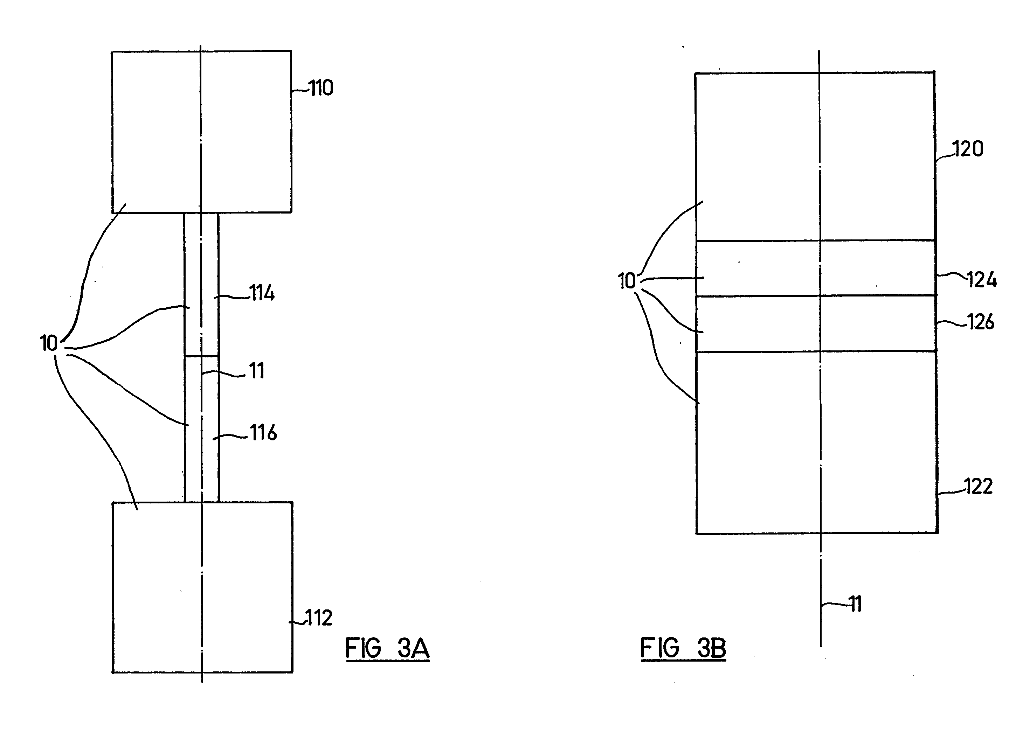

Reference is made in this connection to Figs. 3A and 3B, which illustrate two alternative configurations of permanent magnet assemblies 10. In the embodiment of Fig. 3A, the permanent magnet assembly comprises a pair of spaced magnets 110 and 112 having equal and opposite magnetization in directions along the longitudinal axis 11. Disposed along the longitudinal axis 11 in intermediate touching relationship to magnets 110 and 112 are magnets 114 and 116, of generally smaller cylindrical cross sectional diameter than magnets 110 and 112 and having equal and opposite magnetization in direcions along the longitudinal axis 11. In this embodiment the magnetization direction of magnets 110 and 114 is the same, as is the magnetization direction of magnets 112 and 116.

Referring now to Fig. 3B, there is seen an alternative embodiment of magnet assembly. Here, the magnet assembly comprises a pair of spaced magnets 120 and 122 having equal and opposite magnetization in directions along the longitudinal axis 11. Disposed along the longitudinal axis 11 in intermediate touching relationship to magnets 120 and 122 are magnets 124 and 126, of generally similar cylindrical cross sectional diameter to magnets 120 and 122 and having equal and opposite magnetization in directions along the longitudinal axis 11. In this embodiment the magnetization directions of magnets 120 and 124 are opposite, as are the magnetization directions of magnets 122 and 126.

Permanent magnet 10 preferably has uniform magnetization substantially along the permanent magnet magnetization axis 12 coaxial with the longitudinal axis 11 of the bore hole. The permanent magnet is typically formed of a ferrite permanent material such as Arnox or Permadure. It is essential that the permanent magnet material be non-conductive.

The first portion 6 also comprises one or more coil windings 16, which are preferably arranged on the permanent magnet surface intermediate the magnets such that each coil turn lies in a plane substantially perpendicular to the longitudinal axis 11. Specifically, the axis 13 of the coil winding 16 is coaxial with longitudinal axis 11. The permanent magnet 10 and coil windings 16 are preferably housed in a non-conductive, non-ferromagnetic protective housing 18. The housing and its contents hereinafter will be referred to as a probe 19.

The coil windings 16, together with a transmitter/receiver (T/R) matching circuit 20 define a transmitter/receiver (T/R) circuit. T/R matching circuit 20 typically includes a resonance capacitor, a T/R switch and both to-transmitter and to-receiver matching circuitry and is coupled to a RF power amplifier 24 and to a receiver preamplifier 26.

Disposed in a housing indicated by block 30 is control circuitry for the logging apparatus including a computer 32, which provides a control output to a pulse programmer 34 which receives an RF input from a variable frequency RF source 36. Pulse programmer 34 controls the operation of the variable frequency RF source 36 as well as an RF driver 38, which receives an input from variable frequency RF source 36 and outputs to RF power amplifier 24.

The output of RF receiver preamplifier 26 is supplied to an RF receiver 40 which receives an input from a phase shifter 44. Phase shifter 44 receives an input from variable frequency RF source 36. Receiver 40 outputs via an A/D converter with a buffer 46 to computer 32 for providing desired well logging output data for further use and analysis.

All of the elements described hereinabove which are normally contained in housing 28 and/or housing 30 may be located either above ground or alternatively may be passed through the bore hole.

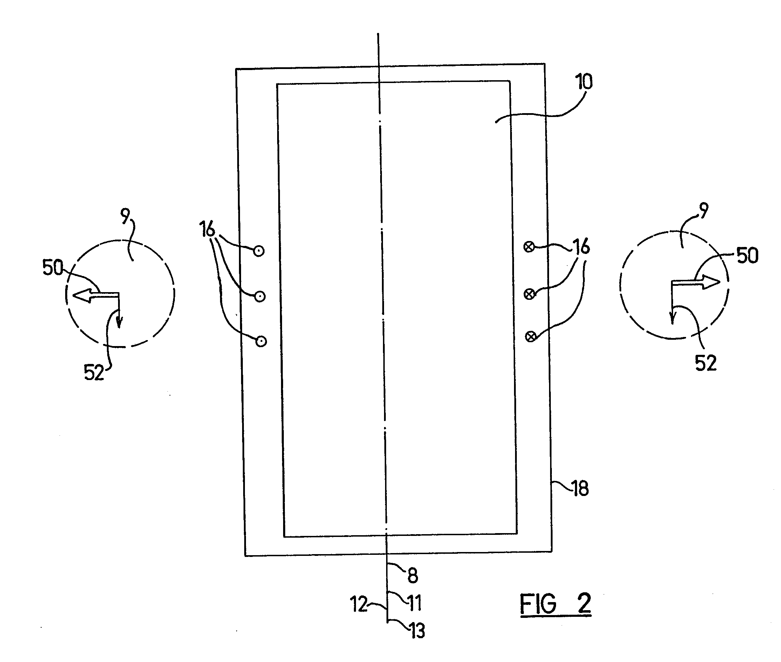

Reference is now made to Fig. 2, which illustrates the magnetic field direction arrangement of the static magnetic field (Arrows 50) and the RF magnetic field (Arrows 52) in the region 9 (Fig. 1) containing materials sought to be analyzed.

In well logging applications of the present invention, it is preferred that the static magnet field amplitude be uniform within toroidal region 9.

All the nuclear moments in the material to be analyzed are arranged generally about the direction of the static magnetic field generated by the permanent magnet 10. According to a preferred embodiment of the present invention, the direction of the RF magnetic field is substantially perpendicular to the static magnetic field in the region 9. Such a field arrangement is conventional for NMR experiments and can be used for exciting nuclear bulk magnetization.

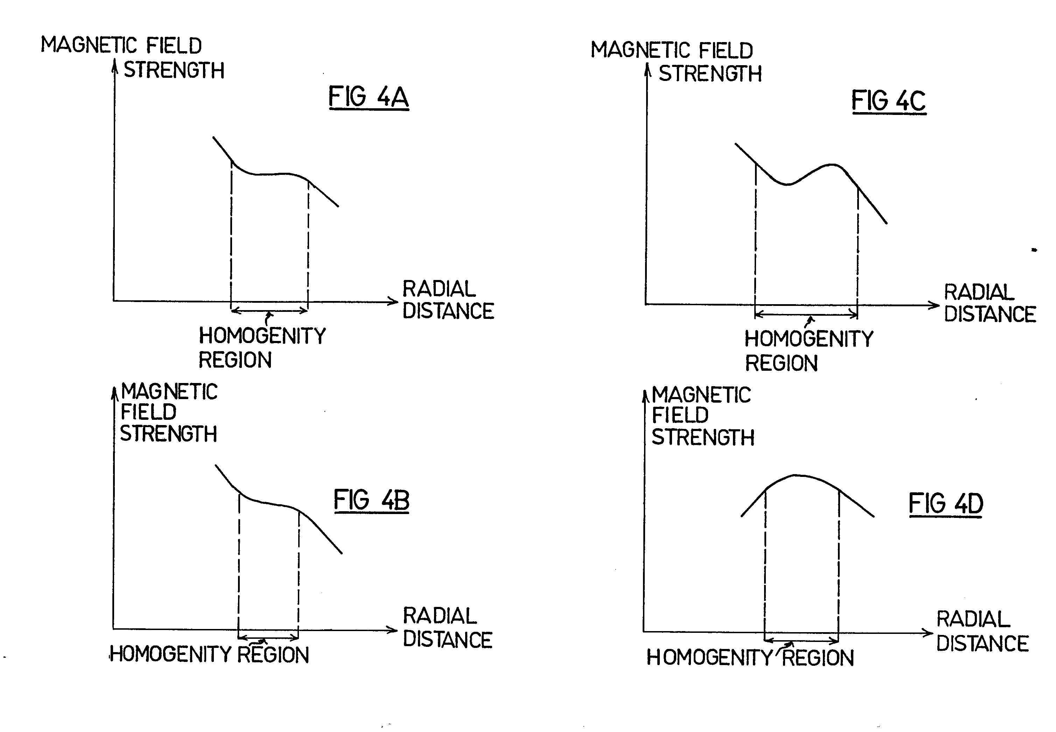

Reference is now made to Figs. 4A-4D which illustrate the magnetic field strength characteristics in the remote region 9 for various magnet configurations described hereinabove. Figs. 4A-4C illustrate characteristics for the magnet configuration of Fig. 3A, while Fig. 4D illustrates characteristics for the magnet configuration of Fig. 3B.

Fig. 4A illustrates an embodiment wherein both the first and second derivatives of the field strength with the radial direction are zero over the region 9. This corresponds to an intermediate situation such as that shown in Fig. 3A.

Fig. 4B illustrates an embodiment wherein the first order partial derivative of the field strength with respect to radial distance is negative over the region 9. This corresponds to a situation wherein the diameter of the cross-section of the second pair of magnets is increased relative to that shown in Fig. 3A, the other parameters being kept constant.

Fig. 4C illustrates an embodiment wherein the first order partial derivative of the field strength with respect to radial distance is equal to zero at two radii in the region 9 and wherein the second order partial derivatives at the two radii are opposite in sign. This corresponds to a situation such as above, but wherein the cross-section of the second pair of magnets is decreased relative to that shown in Fig. 3A.

Fig. 4D illustrates an embodiment wherein the magnetic field strength is maximized and the first order partial derivative of the field strength with respect to radial distance is equal to zero at a given radius within region 9. This corresponds to a situation such as shown in Fig. 3B.

**Claims**

1. Nuclear magnetic resonance sensing apparatus comprising:

at least four magnets (10) operative to generate a static magnetic field in a region (9) remote therefrom containing materials sought to be analyzed, the at least four magnets (10) being arranged along a longitudinal axis (11) and being magnetized in magnetization directions extending generally parallel to said longitudinal axis (11);

means (16,20,24) for generating a radio frequency magnetic field in said remote region (9) for exciting nuclei of the materials sought to be analyzed; and

means (16,20,26) for receiving nuclear magnetic resonance signals from the excited nuclei and for providing an output indication of the properties of the materials sought to be analyzed.

2. Apparatus according to claim 1, wherein said at least four magnets comprise a first pair of magnets (110,112) having opposite magnetization directions and being spaced along the longitudinal axis (11), and a second pair of magnets (114,116) disposed intermediate the first pair of magnets (110,112) along the longitudinal axis (11).

3. Apparatus according to claim 2, wherein said second pair of magnets (124,126) have magnetization directions opposite to the magnetization directions of adjacent ones of the first pair of magnets (120,122).

4. Apparatus according to claim 2, wherein said second pair of magnets (114,116) have magnetization directions parallel to the magnetization directions of adjacent ones of the first pair of magnets (110,112).

5. Apparatus according to any one of the preceding claims, wherein said at least four magnets (10) are each of generally circular cylindrical configuration.

6. Apparatus according to any one of the preceding claims, wherein said at least four magnets (10) comprise permanent magnets.

7. Apparatus according to any one of claims 1 to 5, wherein said at least four magnets (10) comprise electromagnets.

8. Apparatus according to any one of the preceding claims, wherein said at least four magnets (10) are operative for generating a static magnetic field in a well bore hole (7).

9. Apparatus according to any one of the preceding claims, comprising means for displacing said at least four magnets (10), said means for generating a radio frequency magnetic field and said receiving means along a bore hole (7), thereby to enable a plurality of nuclear magnetic resonance measurements to be carried out therealong.

10. Nuclear magnetic resonance sensing apparatus comprising:

at least four ferrite permanent magnets (10) operative to generate a static magnetic field in a region (9) remote therefrom containing materials sought to be analyzed, said at least four ferrite permanent magnets (10) being of generally cylindrical configuration, the at least four ferrite permanent magnets (10) being arranged along a longitudinal axis and being magnetized in magnetization directions extending generally parallel to said longitudinal axis;

means (16,20,24) for generating a radio frequency magnetic field in said remote region (9) for exciting nuclei of the materials sought to be analyzed, said generating means comprising at least one coil (16) wound about the surface of said at least four ferrite permanent magnets (10) whereby the coil turns lie in planes substantially perpendicular to said longitudinal axis intermediate the magnets; and

receiving means (16,20,26) for receiving, via said at least one coil (16), nuclear magnetic resonance signals from the materials to be analyzed and for providing an output indication of the properties of the materials sought to be analyzed.

11. Apparatus according to claim 10, wherein said at least four ferrite permanent magnets (10) have an overall configuration of a circular cylinder.

12. Apparatus according to claim 10 or claim 11, comprising means for displacing said at least four ferrite permanent magnets (10), said means for generating a radio frequency magnetic field and said receiving means along a bore hole (7), thereby to enable a plurality of nuclear magnetic resonance measurements to be carried out therealong.

13. A method of nuclear magnetic resonance sensing comprising the steps of:

providing at least four magnets (10) defining a longitudinal axis (11) and having substantially uniform magnetization and magnetization directions extending generally parallel to said longitudinal axis (11);

causing said at least four magnets (10) to generate a static magnetic field of generally uniform amplitude in a region (9) remote therefrom containing materials sought to be analyzed, said static magnetic field having a static field direction perpendicular to said longitudinal axis (11) in said remote region (9);

generating a radio frequency magnetic field in said remote region for exciting nuclei of the materials sought to be analyzed and having a radio frequency magnetic field direction substantially perpendicular to said static field direction and parallel to said longitudinal axis (11);

receiving nuclear magnetic resonance signals from the excited nuclei; and

providing in response to the received nuclear magnetic resonance signals an output indication of the properties of the materials sought to be analyzed.

14. A method according to claim 13, wherein said step of generating a static magnetic field comprises the step of generating a static magnetic field in the region (9) surrounding a well bore hole (7).

15. A method according to claim 13 or claim 14, comprising the steps of generating the static magnetic field, generating the radio frequency magnetic field and receiving the nuclear magnetic resonance signals at a plurality of locations along a bore hole (7), thereby to enable a plurality of nuclear magnetic resonance measurements to be carried out therealong.

16. A method of well logging using nuclear magnetic resonance and comprising the steps of:

generating a static magnetic field substantially perpendicular to the axis of a bore hole (7) in a region (9) surrounding the bore hole which region includes materials sought to be analyzed;

generating a radio frequency magnetic field in said region (9) in a direction substantially parallel to the axis (11) of the bore hole (7) and substantially perpendicular to the static magnetic field for exciting nuclei of the materials sought to be analyzed; and

receiving nuclear magnetic resonance signals from the excited nuclei.

17. A method according to claim 16, comprising the step of providing an output indication of the properties of the materials sought to be analyzed on the basis of the received nuclear magnetic resonance signals.

18. A method of nuclear magnetic resonance sensing comprising the steps of:

providing at least four non-conductive permanent magnets (10) of generally cylindrical configuration and defining a longitudinal axis (11), said at least four permanent magnets (10) having substantially uniform magnetization in a direction extending generally along a magnetization axis parallel to said longitudinal axis (11);

causing said at least four magnets (10) to generate a static magnetic field of generally uniform amplitude which is substantially azimuthally symmetric with respect to said longitudinal axis (11) in a generally toroidal region (9) centred about said longitudinal axis (11) and remote therefrom, said region (9) containing materials sought to be analyzed, said static magnetic field having a static field direction perpendicular to said longitudinal axis (11) in said remote region;

generating a radio frequency magnetic field of generally uniform and azimuthally symmetric amplitude in said remote region (9) for exciting nuclei of the materials sought to be analyzed and having a radio frequency magnetic field direction substantially perpendicular to said static field direction and substantially parallel to said longitudinal axis (11);

receiving nuclear magnetic resonance signals from the materials sought to be analyzed; and

providing in response to the received nuclear magnetic resonance signals an output indication of the properties of the materials sought to be analyzed.

0295134

FIG 1

FIG 2

FIG 3A

FIG 3B

0295134

FIG 4C

MAGNETIC FIELD STRENGTH

RADIAL DISTANCE

HOMOGENITY REGION

FIG 4D

MAGNETIC FIELD STRENGTH

RADIAL DISTANCE

HOMOGENITY REGION

FIG 4A

MAGNETIC FIELD STRENGTH

RADIAL DISTANCE

HOMOGENITY REGION

FIG 4B

MAGNETIC FIELD STRENGTH

RADIAL DISTANCE

HOMOGENITY REGION